# EUROPEAN PATENT APPLICATION

(11) **EP 4 839 057 A1**
(43) Date of publication of application: **11.11.2026**
(21) Application number: 25806781.8
(22) Date of filing: 27.04.2025
(51) Int. Cl.: H10F 77/1223, H10F 10/14

(54) **SILICON SUBSTRATE, SOLAR CELL, CELL MODULE, AND PHOTOVOLTAIC SYSTEM**

(30) Priority: 20.05.2024 CN 202410628188
(71) Applicant: Zhuhai Fushan Aiko Solar Energy Technology Co., Ltd., FushanIndustrial Park, Doumen District Zhuhai Guangdong 519000 (CN); Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); DING, Sen, Jinhua, Zhejiang 322000 (CN); ZHANG, Junkai, Jinhua, Zhejiang 322000 (CN); CHEN, Gang, Jinhua, Zhejiang 322000 (CN)
(74) Representative: EP&C
(86) International application number: PCT/CN2025/091577
(87) International publication number: WO 2025/241842

(57) **Abstract**

The present disclosure is applicable to the technical field of solar cells and provides a silicon substrate, a solar cell, a cell assembly and a photovoltaic system. The silicon substrate is simultaneously doped with P-type doping elements and N-type doping elements, wherein the P-type doping element includes at least one of boron, aluminum, gallium, indium and thallium, and the N-type doping element includes at least one of phosphorus, arsenic, antimony and bismuth; and a sum of doping concentrations of the P-type doping elements and a sum of doping concentrations of the N-type doping elements are both greater than 10¹² atoms/cm³, an absolute value of a difference between the sum of the doping concentrations of the P-type doping elements and the sum of the doping concentrations of the N-type doping elements is less than 10¹⁴ atoms/cm³, and a resistivity of the silicon substrate after the thermal donor annihilation treatment is greater than 50 ohm.cm. In this way, by simultaneously doping with the P-type doping elements and the N-type doping elements each having a doping concentration greater than 10¹² atoms/cm³, and controlling the absolute value of the concentration difference between them to be less than 10¹⁴ atoms/cm³, the silicon substrate is compensationally doped, so that the solar cell can achieve improved efficiency even when using a high-resistivity silicon substrate.

## Description

### Cross-Reference to Related Application

The present disclosure claims priority to Chinese Patent Application No. 202410628188.8, filed to the China National Intellectual Property Administration on May 20, 2024 and entitled "Silicon Substrate, Solar Cell, Cell assembly and Photovoltaic System", which is incorporated herein by reference in its entirety.

### Technical Field

The present disclosure relates to the technical field of solar cells, and in particular to a silicon substrate, a solar cell, a cell assembly and a photovoltaic system.

### Background

Currently, in order to manufacture a silicon substrate for fabricating solar cells, it is generally achieved by adding doping elements from Group III or Group V such as phosphorus or boron in the process of forming a silicon ingot. In the related art, in order to reduce resistive losses so as to ensure the efficiency of the solar cell, an inherent understanding has been formed in the field of solar technology, which is to design the resistivity of the silicon substrate to be within a reasonable range that is relatively small and with relatively small fluctuations. For example, in order to guarantee the performance of the solar cell, the resistivity range of the silicon substrate can be controlled within a relatively small range such as 1-3 ohm.cm or 0.4-1.1 ohm.cm, thereby effectively controlling resistive losses to ensure efficiency.

However, such inherent understanding has limited the further development of the technology. Moreover, adopting such a technical solution provides only limited improvement to the efficiency of the solar cell. Accordingly, how to further improve the conversion efficiency of the solar cell has become a technical problem studied a person skilled in the art.

### Summary

The present disclosure provides a silicon substrate, a solar cell, a cell assembly and a photovoltaic system, which are intended to solve the technical problem in the related art of how to further improve the conversion efficiency of solar cells.

The present disclosure is implemented as follows: the silicon substrate in some embodiments of the present disclosure is used for the solar cell, the silicon substrate is doped with both P-type doping elements and N-type doping elements, the P-type doping element includes at least one of boron, aluminum, gallium, indium and thallium, and the N-type doping element includes at least one of phosphorus, arsenic, antimony and bismuth; and
a sum of doping concentrations of the P-type doping elements and a sum of doping concentrations of the N-type doping elements are both greater than 10¹² atoms/cm³, an absolute value of a difference between the sum of the doping concentrations of the P-type doping elements and the sum of the doping concentrations of the N-type doping elements is less than 10¹⁴ atoms/cm³, and a resistivity of the silicon substrate after the thermal donor annihilation treatment is greater than 50 ohm.cm.

In some embodiments, the sum of the doping concentrations of the P-type doping elements and the sum of the doping concentrations of the N-type doping elements are both greater than 10¹⁴ atoms/cm³.

In some embodiments, the sum of the doping concentrations of the P-type doping elements and the sum of the doping concentrations of the N-type doping elements are both greater than 10¹⁵ atoms/cm³.

In some embodiments, the absolute value of the difference between the sum of the doping concentrations of the P-type doping elements and the sum of the doping concentrations of the N-type doping elements is less than 5*10¹³ atoms/cm³.

In some embodiments, the resistivity of the silicon substrate after the thermal donor annihilation treatment is greater than 100 ohm.cm.

In some embodiments, the resistivity of the silicon substrate after the thermal donor annihilation treatment is greater than 200 ohm.cm.

In some embodiments, the resistivity of the silicon substrate after the thermal donor annihilation treatment is greater than 500 ohm.cm.

In some embodiments, the resistivity of the silicon substrate after the thermal donor annihilation treatment is greater than 1000 ohm.cm.

In some embodiments, the resistivity of the silicon substrate after the thermal donor annihilation treatment is greater than 5000 ohm.cm.

In some embodiments, a thickness of the silicon substrate is 30 um to 300 um.

In some embodiments, the silicon substrate is a monocrystalline silicon substrate.

The present disclosure further provides a solar cell, which is a back contact solar cell. The solar cell includes:
the silicon substrate according to any one of the above embodiments, wherein a back surface of the silicon substrate has several first regions and several second regions, and the several first regions and the several second regions are arranged alternately in sequence at intervals;
first passivated contact structures stacked on the first regions;
second passivated contact structures stacked on the second regions, the polarity of the second passivated contact structures being different from that of the first passivated contact structures; and
a back passivation film layer stacked on the first passivated contact structures and the second passivated contact structures.

In some embodiments, each of the first passivated contact structures includes a first tunneling layer and a first polarity doping layer stacked on the first tunneling layer, the first polarity doping layer including at least one of doped polysilicon, doped amorphous silicon and doped microcrystalline silicon; and
each of the second passivated contact structures includes a second tunneling layer and a second polarity doping layer stacked on the second tunneling layer, the second polarity doping layer including at least one of doped polysilicon, doped amorphous silicon, and doped microcrystalline silicon, and the second polarity doping layer having a polarity opposite to that of the first polarity doping layer.

In some embodiments, trenches are provided between the first regions and the second regions, the first passivated contact structures are isolated from the second passivated contact structures by the trenches, and the trenches do not have a doped layer formed by doping elements from Group III or Group V; or
a dielectric film or an intrinsic silicon film layer is provided between the first regions and the second regions, and the first regions are isolated from the second regions by the dielectric film or the intrinsic silicon film layer.

In some embodiments, the front surface of the silicon substrate has no front surface field formed by doping, or the front surface of the silicon substrate has a front surface field with a surface doping concentration of less than 5*10¹⁸ atoms/cm³.

The present disclosure further provides a solar cell, which is a bifacial contact solar cell. The solar cell includes:
the silicon substrate according to any one of the embodiments above, wherein the silicon substrate has a first surface and a second surface opposite to each other;
a third passivated contact structure stacked on the first surface; and
a fourth passivated contact structure stacked on the second surface

In some embodiments, the third passivated contact structure includes a third tunneling layer and a third polarity doping layer stacked on the third tunneling layer, the third polarity doping layer including at least one of doped polysilicon, doped amorphous silicon and doped microcrystalline silicon; and
the fourth passivated contact structure includes a fourth tunneling layer and a fourth polarity doping layer stacked on the fourth tunneling layer, the fourth polarity doping layer including at least one of doped polycrystalline silicon, doped amorphous silicon and doped microcrystalline silicon, and the fourth polarity doping layer having a polarity opposite to that of the third polarity doping layer.

The present disclosure further provides a cell assembly, which includes a solar cell according to any one of the embodiments above.

The present disclosure further provides a photovoltaic system, which includes the described cell assembly.

In the silicon substrate, the solar cell, the cell assembly and the photovoltaic system of the embodiments of the present disclosure, two different types of P-type and N-type doping elements are respectively doped in the silicon substrate 10, and by controlling the doping concentrations of the P-type doping elements and the N-type doping elements and the difference between the doping concentrations of the P-type doping elements and the N-type doping elements to be less than 10¹⁴ atoms/cm³, a resistivity of the silicon substrate after a thermal donor annihilation treatment can have greater than 50 ohm.cm after thermal donor annihilation. In the back contact solar cell, the structure design having the first passivated contact structure, the second passivated contact structure and the back passivation film layer is used to achieve back surface passivation, whereas in the bifacial contact solar cell, the third passivated contact structure and the fourth passivated contact structure are used to respectively passivate the first surface and the second surface. In this way, by simultaneously doping with the P-type doping elements and N-type doping elements, and controlling the concentration difference between them, the silicon substrate is compensationally doped, so that the silicon substrate 10 has a resistivity greater than 50 ohm.cm after thermal donor annihilation. The silicon substrate of the present disclosure is applied to the back contact solar cell utilizing surface passivation technology with the first passivated contact structure, the second passivated contact structure and the back passivation film layer, or to the bifacial contact solar cell utilizing the third passivated contact structure and the fourth passivated contact structure, the surface recombination at the back surface of the back contact solar cell and at the surfaces of the bifacial contact solar cell can be significantly reduced. As a result, the surface recombination lifetime of the back contact solar cell and the bifacial contact solar cell can reach or even exceed the bulk lifetime, thereby making the effective lifetime of the entire solar cell predominantly determined by the bulk region. In this way, the concentration of nonequilibrium carriers throughout the bulk transport channels can be maintained at a high level, thereby reducing significant resistive losses caused by locally low nonequilibrium carrier concentrations and thus ensuring the conversion efficiency of the solar cell. That is to say, in the present disclosure, the silicon substrate can be doped by simultaneously using two types of doping elements of different polarities, while controlling their doping concentrations and the concentration difference between them, so that the solar cell can achieve improved efficiency even when using a high-resistivity silicon substrate, thereby breaking the existing inherent understanding.

Additional aspects and advantages of the present disclosure will be given in part in the following descriptions, become apparent in part from the following descriptions, or be learned by practice of the present disclosure.

### Brief Description of the Drawings

Fig. 1 is a schematic module diagram of a photovoltaic system provided according to embodiments of the present disclosure;
Fig. 2 is a schematic module diagram of a cell assembly provided according to embodiments of the present disclosure;
Fig. 3 is a schematic diagram of a cross-sectional structure of a back contact solar cell provided according to embodiments of the present disclosure;
Fig. 4 is a schematic diagram of a cross-sectional structure of a bifacial contact solar cell provided according to embodiments of the present disclosure;
Fig. 5 is another schematic diagram of a cross-sectional structure of a back contact solar cell provided according to embodiments of the present disclosure;
Fig. 6 is a graph of the relationship between the silicon substrate resistivity and efficiency loss of a solar cell in the related art;
Fig. 7 is a graph of the relationship between the bulk resistive loss and bulk Auger recombination loss and the silicon substrate resistivity of a PERC cell in the related art;
Fig. 8 is a graph of the relationship between the conversion efficiency of a PERC cell and the silicon substrate resistivity in the related art;
Fig. 9 is a graph of the relationship between the bulk resistance loss and bulk Auger recombination loss and the silicon substrate resistivity of a back contact solar cell and a bifacial contact solar cell provided according to embodiments of the present disclosure;
Fig. 10 is a graph of the relationship between the carrier concentration and the silicon substrate resistivity of a back contact solar cell and a bifacial contact solar cell provided according to embodiments of the present disclosure;
Fig. 11 is a graph of the relationship between the silicon substrate resistivity and the cell conversion efficiency of a back contact solar cell and a bifacial contact solar cell provided according to embodiments of the present disclosure;
Fig. 12 is a graph of the relationship between the silicon substrate resistivity and the maximum power point current of a back contact solar cell and a bifacial contact solar cell provided according to embodiments of the present disclosure; and
Fig. 13 is a graph of the relationship between the concentration of nonequilibrium carriers and the SRH minority carrier lifetime in a back contact solar cell and a bifacial contact solar cell provided according to embodiments of the present disclosure under different resistivities.

### Detailed Description of the Embodiments

To make the objectives, technical solutions, and advantages of the present disclosure clearer, hereinafter, the present disclosure will be further described in detail below in conjunction with the accompanying drawings and embodiments. Examples of the embodiments are shown in the accompanying drawings, in which same or similar reference signs represent same or similar elements or elements having same or similar functions. The embodiments described herein with reference to the accompanying drawings are illustrative, and only used to explain the present disclosure, and therefore the embodiments cannot be understood as limitation to the present disclosure. In addition, it should be understood that the specific embodiments described herein are only used to explain the present disclosure, and are not intended to limit the present disclosure.

In the illustration of the present disclosure, it should be understood that the orientation or positional relationships indicated by the terms such as "upper", "lower", "back surface", "front surface", etc. are the orientation or positional relationships based on those as shown in the accompanying drawings, are only used to facilitate the illustration of the present disclosure and to simplify the illustration, rather than indicating or implying that an apparatus or element referred to must have a specific orientation, and be constructed and operated in the specific orientation, and therefore said terms cannot be understood as limitation to the present disclosure.

In the present disclosure, unless specified or limited otherwise, a first feature being "above" or "below" a second feature may include the first feature being in direct contact with the second feature, and may also include the first feature and the second feature being not in direct contact with each other, but being in contact via an additional feature therebetween. Furthermore, a first feature being "over", "above", and "on" a second feature may include the first feature being directly above and obliquely above the second feature, or merely mean that the first feature having a horizontal height higher than that of the second feature. A first feature being "below", "beneath" or "under" a second feature includes the first feature being directly below or obliquely below the second feature, or merely mean that the first feature having a horizontal height lower than that of the second feature.

The following disclosure provides many different embodiments or examples for implementing different structures of the present disclosure. In order to simplify the disclosure of the present disclosure, the components and arrangements of specific examples are described below. Certainly, they are merely examples and are not intended to limit the present disclosure. In addition, the present disclosure may repeat the reference signs and/or letters in the various examples for the sake of simplicity and clarity, which do not in itself indicate relationships between the various embodiments and/or arrangements discussed. In addition, the present disclosure provides the examples of various specific processes and materials, but one of ordinary skill in the art can recognize the applications of other processes and/or use of other materials.

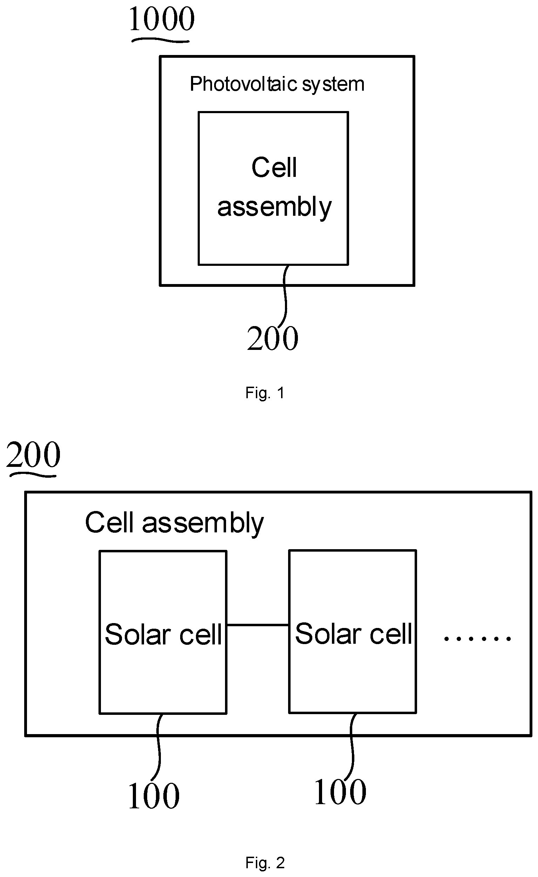

Please refer to Fig. 1, the photovoltaic system 1000 in the embodiments of the present disclosure may include the cell assembly 200 in the embodiments of the present disclosure.

Please refer to Fig. 2, the cell assembly 200 in the embodiments of the present disclosure may include a plurality of solar cells 100 in the embodiments of the present disclosure. Specifically, the solar cell 100 in the embodiments of the present disclosure may be a back contact solar cell or a bifacial contact solar cell.

The plurality of solar cells 100 in the cell assembly 200 may be sequentially connected in series to form a cell string. The cell strings may be connected in series, parallel, or a combination of series and parallel to achieve current output convergence. For example, the connection between the solar cells may be implemented by means of soldering solder ribbons, and the connection between the cell strings may be implemented by busbars.

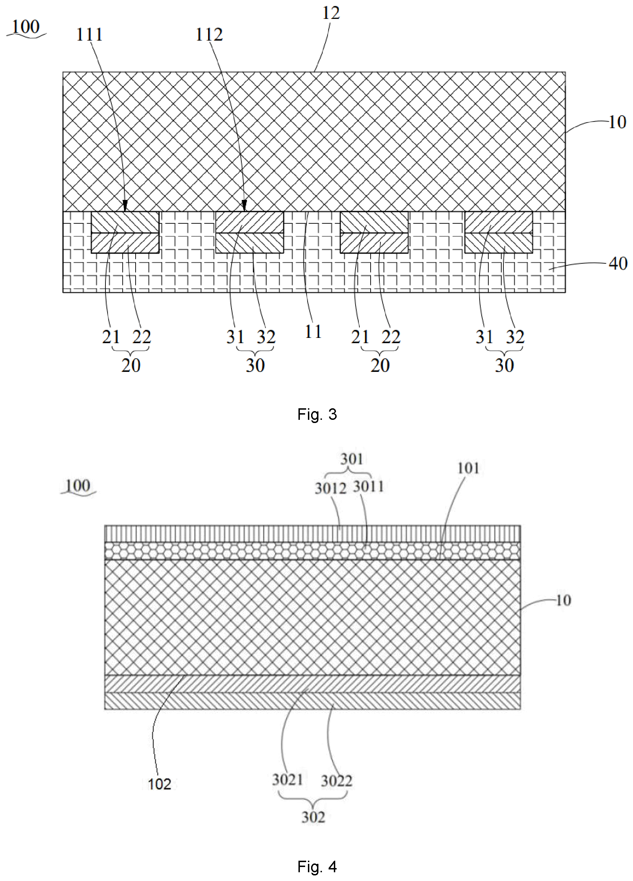

Please refer to Fig. 3, in some embodiments, the solar cell 100 in the embodiments of the present disclosure may be a back contact solar cell, and in such a case, the solar cell 100 may include a silicon substrate 10, first passivated contact structures 20, second passivated contact structures 30 and a back passivation film layer 40 in the embodiments of the present disclosure.

Please refer to Fig. 4, in some embodiments, the solar cell 100 in the embodiments of the present disclosure may also be a bifacial contact solar cell, and in such a case, the solar cell 100 may include a silicon substrate 10, a third passivated contact structure 301 and a fourth passivated contact structure 302 in embodiments of the present disclosure. The silicon substrate 10 has a first surface 101 and a second surface 102 opposite to each other, and the first surface 101 and the second surface 102 may be a front surface and a back surface of the silicon substrate 10, respectively.

The silicon substrate 10 in the embodiment of the present disclosure is doped with both a P-type doping element and an N-type doping element, the P-type doping element includes at least one of boron, aluminum, gallium, indium and thallium, and the N-type doping element includes at least one of phosphorus, arsenic, antimony and bismuth; and
a sum of doping concentrations of the P-type doping elements and a sum of doping concentrations of the N-type doping elements are both greater than 10¹² atoms/cm³, an absolute value of a difference between the sum of the doping concentrations of the P-type doping elements and the sum of the doping concentrations of the N-type doping elements is less than 10¹⁴ atoms/cm³, and a resistivity of the silicon substrate 10 after the thermal donor annihilation treatment is greater than 50 ohm.cm.

It should be noted that, in the present disclosure, "the sum of doping concentrations of the P-type doping elements" refers to the sum of doping concentrations of all P-type doping elements doped in the silicon substrate 10. That is to say, if the silicon substrate 10 is only doped with one of boron, aluminum, gallium, indium and thallium, then the sum of the doping concentrations of the P-type doping elements represents the doping concentration of this element, and if the silicon substrate 10 is doped with two or more of these elements, then the sum of doping concentrations of the P-type doping elements represents the sum of the doping concentrations of the respective P-type doping elements.

By the same reasoning, "the sum of doping concentrations of the N-type doping elements" refers to the sum of doping concentrations of all N-type doping elements doped in the silicon substrate 10. That is to say, if the silicon substrate 10 is only doped with one of phosphorus, arsenic, antimony and bismuth, then the sum of the doping concentrations of the N-type doping elements represents the doping concentration of this element, and if the silicon substrate 10 is doped with two or more of these elements, then the sum of doping concentrations of the N-type doping elements represents the sum of the doping concentrations of the respective N-type doping elements. If there are the same or similar descriptions hereinafter, reference can be made to this content for understanding.

As shown in Fig. 3, in the back contact solar cell, the back surface 11 of the silicon substrate 10 may have several first regions 111 and several second regions 112, and the several first regions 111 and the several second regions 112 are arranged alternately in sequence at intervals. The first passivated contact structure 20 is stacked on the first region 111, the second passivated contact structure 30 is stacked on the second region 112, the polarity of the second passivated contact structure 30 is different from that of the first passivated contact structure 20, one of which is P-type, and the other is N-type. The back passivation film layer 40 is stacked on the first passivated contact structures 20 and the second passivated contact structures 30. Specifically, the back passivation film layer 40 may cover the entire back surface 11 of the silicon substrate 10.

Certainly, it should be understood that, in the present disclosure, the back contact solar cell can further include a front passivation film (not shown) arranged on the front surface 12 of the silicon substrate 10, and the front passivation film can achieve effective passivation of the front surface.

Please refer to Fig. 4, in a bifacial contact solar cell, a third passivated contact structure 301 is stacked on a first surface 101, and a fourth passivated contact structure 302 is stacked on a second surface 102. Specifically, the third passivation structure 301 has a different polarity than the fourth passivated contact structure 302, one of which is a P-type and the other is an N-type.

In the silicon substrate 10, the solar cell 100, the cell module 200, and the photovoltaic system 1000 of the embodiments of the present disclosure, two different types of P-type and N-type doping elements are respectively doped into the silicon substrate 10, and by controlling the sum of doping concentrations of the P-type doping elements and the sum of doping concentrations of the N-type doping elements to be greater than 10¹² atoms/cm³, and the absolute value of the difference between the doping concentrations to be less than 10¹⁴ atoms/cm³, the silicon substrate 10 can have a resistivity greater than 50 ohm.cm after thermal donor annihilation. In the back contact solar cell, the structure design having the first passivated contact structures 20, the second passivated contact structures 30 and the back passivation film layer 40 is used to achieve back surface passivation, whereas in the bifacial contact solar cell, the third passivated contact structure 301 and the fourth passivated contact structure 302 are used to respectively passivate the first surface 101 and the second surface 102.

In this way, the silicon substrate 10 is simultaneously doped with the P-type doping elements and the N-type doping elements each having a doping concentration greater than 10¹² atoms/cm³, and the concentration difference between their doping concentrations is controlled, the silicon substrate 10 is compensationally doped (i.e. the absolute value of the difference between their doping concentrations being controlled within the range of less than 10¹⁴ atoms/cm³), so that the silicon substrate 10 has a resistivity greater than 50 ohm.cm after thermal donor annihilation. Meanwhile, the silicon substrate 10 of the present disclosure is applied to the back contact solar cell utilizing surface passivation technology with the first passivated contact structures 20, the second passivated contact structures 30 and the back passivation film layer 40, or to the bifacial contact solar cell utilizing the third passivated contact structure 301 and the fourth passivated contact structure 302, the surface recombination at the back surface 11 of the back contact solar cell and at the surfaces of the bifacial contact solar cell can be significantly reduced. As a result, the surface recombination lifetime of the back contact solar cell and the bifacial contact solar cell can reach or even exceed the bulk lifetime, thereby making the effective lifetime of the entire solar cell predominantly determined by the bulk region. In this way, the concentration of nonequilibrium carriers throughout the bulk transport channels can be maintained at a high level, thereby reducing significant resistive losses caused by locally low nonequilibrium carrier concentrations and thus ensuring the conversion efficiency of the solar cell 100. That is to say, in the present disclosure, the silicon substrate 10 can be doped by simultaneously using two types of doping elements of different polarities, while controlling their doping concentrations and the concentration difference between them, so that the solar cell 100 can achieve improved efficiency even when using a high-resistivity silicon substrate 10, thereby breaking the existing inherent understanding.

Specifically, in the present disclosure, the silicon substrate 10 is preferably a monocrystalline silicon substrate. Certainly, in some embodiments, it may also be a polysilicon substrate, which is not specifically limited herein.

In addition, it is not difficult to understand that in the present disclosure, in the silicon substrate 10, if the sum of the doping concentrations of the P-type doping elements is greater than the sum of the doping concentrations of the N-type doping elements, the silicon substrate 10 shows the characteristics of the P-type silicon substrate, and if the sum of the doping concentrations of the P-type doping elements is less than the sum of the doping concentrations of the N-type doping elements, the silicon substrate 10 shows the characteristics of the N-type silicon substrate.

It should be noted that, in the present disclosure, the absolute value of the difference between the sum of doping concentrations of P-type doping elements and the sum of doping concentrations of N-type doping elements being less than 10¹⁴ atoms/cm³ means that the absolute value of the concentrations difference between them is greater than 0 and less than 10¹⁴ atoms/cm³.

In some embodiments, in the silicon substrate 10, the sum of the doping concentrations of the P-type doping elements and the sum of the doping concentrations of the N-type doping elements may preferably both be greater than 10¹⁴ atoms/cm³. Preferably, the sum of the doping concentrations of the P-type doping elements and the sum of the doping concentrations of the N-type doping elements may both be greater than 10¹⁵ atoms/cm³.

In this way, by adjusting the sum of the doping concentrations of the P-type doping elements and the sum of the doping concentrations of the N-type doping elements, the absolute value of the difference between the doping concentrations of the P-type doping elements and the N-type doping elements is less than 10¹⁴ atoms/cm³, thereby improving the resistivity of the silicon substrate 10 after thermal donor annihilation.

Preferably, in some embodiments, in the silicon substrate 10, the absolute value of the difference between the sum of the doping concentrations of the P-type doping elements and the sum of the doping concentrations of the N-type doping elements may preferably be less than 5*10¹³ atoms/cm³. For example, the absolute value of the difference may be 10¹³ atoms/cm³, 5*10¹² atoms/cm³, 10¹² atoms/cm³, 5*10¹¹ atoms/cm³, etc., which is not specifically limited herein.

Specifically, the inventors of the present disclosure have found through research and verification that, by optimizing the absolute value 5*10¹³ atoms/cm³ of the difference between the sum of doping concentrations of P-type doping elements and the sum of doping concentrations of N-type doping elements in the silicon substrate 10, the resistivity of the silicon substrate 10 after thermal donor annihilation can be optimized, so that the silicon substrate has a high resistivity and the conversion efficiency can be improved.

In some embodiments, the resistivity of the silicon substrate 10 after the thermal donor annihilation treatment may be greater than 100 ohm.cm. Further, in some embodiments, the resistivity of the silicon substrate 10 after the thermal donor annihilation treatment may be greater than 200 ohm.cm.

Still further, in some embodiments, the resistivity of the silicon substrate 10 after the thermal donor annihilation treatment is greater than 500 ohm.cm, or greater than 1000 ohm.cm, or even greater than 5000 ohm.cm.

As such, the sum of bulk resistance efficiency loss and bulk Auger recombination efficiency loss may be reduced in some embodiments, improving the conversion efficiency.

In some embodiments, the silicon substrate 10 may have a thickness of 30 um to 300 um. In this way, it can prevent the concentration of photogenerated carriers from being too low due to an excessively small thickness of the silicon substrate 10, and can also avoid excessively high costs of the cell due to an excessively large thickness of the silicon substrate 10.

Specifically, the thickness of the silicon substrate 10 may be, for example, 30 um, 40 um, 50 um, 60 um, 70 um, 80 um, 90 um, 100 um, 150 um, 200 um, 250 um, 300 um, or any value between 30 um and 300 um, which is not specifically limited herein.

Please refer to Fig. 3, in some embodiments, in the back contact solar cell, the first passivated contact structure 20 may include a first tunneling layer 21 and a first polarity doping layer 22 stacked on the first tunneling layer 21, and the first polarity doping layer 22 may include at least one of doped polycrystalline silicon, doped amorphous silicon, and doped microcrystalline silicon.

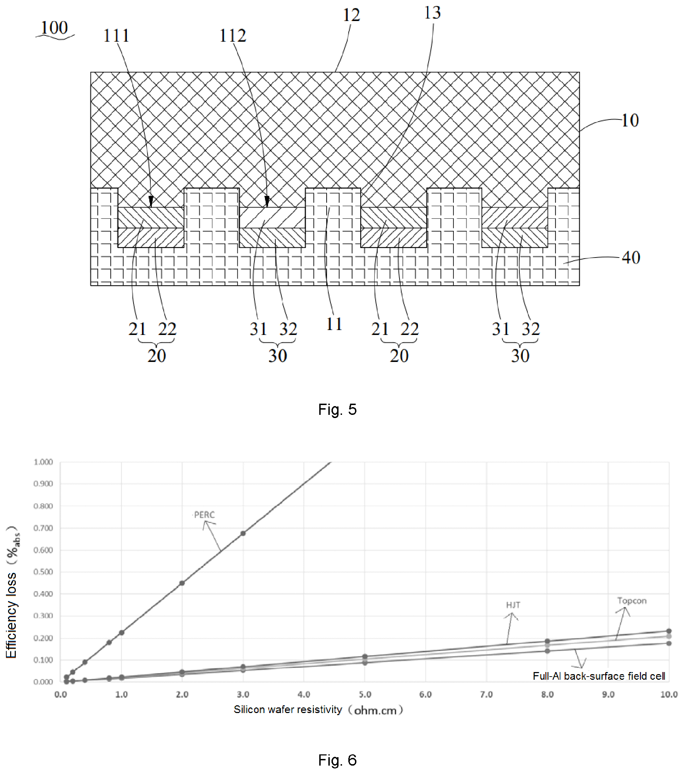

Please refer to Figs. 3 and 5, the second passivated contact structure 30 includes a second tunneling layer 31 and a second polarity doping layer 32 stacked on the second tunneling layer 31, the second polarity doping layer 32 may include at least one of doped polysilicon, doped amorphous silicon and doped microcrystalline silicon, and the second polarity doping layer 32 has a polarity opposite to that of the first polarity doping layer 22. For example, if the first polarity doping layer 22 is a P-type doping layer, the second polarity doping layer 32 may be an N-type doping layer, and if the first polarity doping layer 22 is an N-type doping layer, the second polarity doping layer 32 may be a P-type doping layer.

In this way, in the back contact solar cell, the first passivated contact structure 20 and the second passivated contact structure 30 adopt the described structure design to enable the back surface recombination of the back contact solar cell to be greatly reduced, and thus the surface recombination lifetime can reach or exceed the bulk lifetime, thereby making the effective lifetime of the back contact solar cell to be predominantly determined by the bulk lifetime.

Specifically, in such embodiments, the first tunneling layer 21 and the second tunneling layer 31 may be a thin-film oxide layer or a thin-film intrinsic silicon layer, which is not specifically limited herein.

In some embodiments, in the back contact solar cell, the front surface 12 of the silicon substrate 10 does not have a front surface field, or the front surface 12 of the silicon substrate 10 may have a front surface field with a surface doping concentration less than 5*10¹⁸ atoms/cm³. In this way, the recombination of the front surface 12 of the back contact solar cell can be significantly reduced, and the effective lifetime of the back contact solar cell is more predominantly determined by the bulk lifetime.

Please refer to Fig. 5, in some embodiments, in the back contact solar cell, trenches 13 are formed between the first regions 111 and the second regions 112, the first passivated contact structures 20 are isolated from the second passivated contact structures 30 by the trenches 13, and there is no doping layer formed by doping elements from Group III or Group V on the trenches 13. In this way, the edge recombination of the surface can be reduced.

Specifically, as shown in Fig. 5, the back passivation film layer 40 covers the first passivated contact structures 20, the second passivated contact structures 30 and the trenches 13, that is, the back passivation film layer 40 covers the first passivated contact structures 20, the second passivated contact structures 30 and the regions between the first regions 111 and the second regions 112.

Certainly, in some embodiments, a dielectric film or an intrinsic silicon film layer may also be arranged between the first regions 111 and the second regions 112, and the first regions 111 and the second regions 112 may be isolated from each other by the dielectric film or the intrinsic silicon film layer, so as to achieve the purpose of reducing edge recombination, which is not specifically limited herein. Specifically, the dielectric film may include an insulating film layer of silicon oxide, silicon nitride, or the like.

Please refer to Fig. 4, in some embodiments, in the bifacial contact solar cell, the third passivated contact structure 301 may include a third tunneling layer 3011 and a third polarity doping layer 3012 stacked on the third tunneling layer 3011, and the third polarity doping layer 3012 may include at least one of doped polycrystalline silicon, doped amorphous silicon, and doped microcrystalline silicon.

Please refer to Fig. 4, the fourth passivated contact structure 302 includes a fourth tunneling layer 3021 and a fourth polarity doping layer 3022 stacked on the fourth tunneling layer 3021, the fourth polarity doping layer 3022 may include at least one of doped polysilicon, doped amorphous silicon, and doped microcrystalline silicon, and the fourth polarity doping layer 3022 has a polarity opposite to that of the third polarity doping layer 3012. For example, if the third polarity doping layer 3012 is a P-type doping layer, the fourth polarity doping layer 3022 may be an N-type doping layer, and if the third polarity doping layer 3012 is an N-type doping layer, the fourth polarity doped layer 3022 may be a p-type doping layer.

In this way, the third passivated contact structure 301 and the fourth passivated contact structure 302 adopt the described design to enable the front surface recombination and back surface recombination of the bifacial contact solar cell to be significantly reduced, and thus the surface recombination lifetime can reach or exceed the bulk lifetime, thereby making the effective lifetime of the bifacial contact solar cell to be predominantly determined by the bulk lifetime.

Specifically, the third tunneling layer 3011 and the fourth tunneling layer 3021 may also be a thin-film oxide layer or a thin-film intrinsic silicon layer, which is not specifically limited herein. Certainly, it can also be understood that, in the bifacial contact solar cell, another passivation film layer, such as a silicon nitride film layer, may also be stacked on the third passivated contact structure 301 and the fourth passivated contact structure 302, which is not specifically limited herein.

In some embodiments, during the fabrication of the silicon substrate 10 and the back contact solar cell or the bifacial contact solar cell, phosphorus gettering or surface defect gettering or other effective gettering methods can be used to reduce bulk impurities in the silicon substrate, while an efficient cleaning process, such as an ozone cleaning process, can be used to effectively remove surface impurities, thereby controlling the defects in the silicon substrate 10 at a relatively low level.

Next, the specific background of the present disclosure and the technical effects that can be achieved thereby are described as follows:
During the development of photovoltaic technology, prior to 2015, the large-scale mass production of crystalline silicon solar cells mainly adopted P-type full-Al back-surface field cells, in which boron-doped polycrystalline silicon or silicon wafers were used as substrates, and in order to ensure the cell performance, the resistivity range was typically 1-3 ohm.cm, primarily for the following reasons:
1. If the resistivity is too low (i.e., the boron doping concentration is too high), the bulk minority carrier lifetime will significantly decrease, resulting in a sharp reduction in the effective collection probability of minority carriers. Additionally, an excessively high boron doping concentration will cause the B-O recombination pair concentration generated under operating conditions (under sunlight exposure) to become too high, leading to a significant light-induced degradation effect; and
2. If the resistivity is too high, the resistive loss caused by current transport in the silicon substrate will become excessive.

After 2015, the market share of P-type monocrystalline PERC cells rose rapidly and gradually became mainstream. At the early stage of large-scale mass production of PERC cells, the silicon substrates used were the same as those for full-Al back-surface field cells, i.e., boron-doped P-type substrates with a resistivity range of 1-3 ohm.cm. However, a person skilled in the art soon discovered the limitations of the silicon substrate specification:
1. The localized contact structure on the back of PERC cells significantly increases the losses introduced by bulk resistance, and under the resistivity range of 1-3 ohm.cm, the resistive loss is excessively high; and
2. The bulk lifetime of boron-doped silicon substrates is affected by B-O recombination pairs, and as the resistivity decreases, the minority carrier lifetime significantly drops, leading to excessive recombination loss.

By around 2017, the crystalline silicon industry identified a new approach: adopting Ga-doped low-resistivity P-type silicon substrates for large-scale production. Ga doping resolved the impact of B-O recombination pairs on minority carrier lifetime, thereby enabling a significant improvement in the minority carrier lifetime of low-resistivity silicon substrates. As long as the resistivity is not reduced to a level that caused a substantial increase in Auger recombination, resistivity and recombination loss become approximately unrelated factors.

Thus far, for solar cells, the industry has formed an inherent understanding: lower resistivity can achieve higher conversion efficiency, and the resistivity of silicon substrates for large-scale production has been adjusted to 0.4-1.1 ohm.cm.

Between 2015 and 2021, the efficiency of mass-produced PERC cells increased from 20.5% to 23.0%, while the cost per kilowatt-hour of photovoltaic power rapidly decreased. However, the efficiency had already approached the theoretical performance limit for mass production, and further improvement in efficiency and cost reduction had reached a bottleneck. During the period when PERC mass production was gradually maturing, technicians were already searching for the next-generation technology. In this process, multiple technologies underwent fierce competition, and ultimately three types of cells stood out: phosphorus-doped N-type Topcon, phosphorus-doped N-type HJT, and gallium-doped P-type HPBC. Each of these cells achieved a conversion efficiency exceeding 23%, and evaluations indicated that all of them have the potential to further drive down the cost per kilowatt-hour beyond PERC.

It can be determined from the above that, in the field of photovoltaic technology, in order to ensure the efficiency of solar cells, there is an inherent understanding: 1. the resistivity of silicon substrates is as small as possible; and 2. the upper and lower limits of the resistivity are set.

Specific causes leading to this understanding are set forth below:
First, efficiency loss caused by the silicon substrate resistivity

The power loss due to silicon substrate resistivity is approximately estimated based on the current at the maximum power point (Jₘₚₚ). Specifically, the Jₘₚₚ points of polycrystalline silicon cells, Topcon cells, HJT cells, and PERC cells are approximately 34.3 mA/cm², 39.7 mA/cm², 37.3 mA/cm², and 39.36 mA/cm², respectively. Assuming a silicon substrate thickness of 150 µm, the bulk resistivity losses caused by silicon substrates with different resistivities are calculated under dark conditions. As shown in Fig. 6, Fig. 6 illustrates the relationship between the silicon substrate resistivity (resistivity under dark conditions) and efficiency loss for different types of cells in the related art.

It can be determined from Fig. 6 that as the silicon substrate resistivity increases, the efficiency loss caused by silicon substrate resistance continues to rise, with PERC cells being the most sensitive. This is also the reason why PERC cells are designed with lower resistivity compared to other cell types. Among them, full-Al back-surface field cells, Topcon cells, and HJT cells exhibit a conversion efficiency loss of approximately 0.05% at around 2.5 ohm.cm, and approximately 0.1% at around 5 ohm.cm.

Based on the current module price of 1 RMB/W, and the premium benefit of 0.007 RMB/W gained from each watt of power improvement, conversion efficiency losses of 0.05% and 0.1% will result in revenue losses of approximately 10 million RMB and 20 million RMB per gigawatt of modules, respectively. The profit losses caused by such efficiency losses have a significant impact on the profitability of the module business, and may even determine whether an enterprise achieves a profit or incurs a loss.

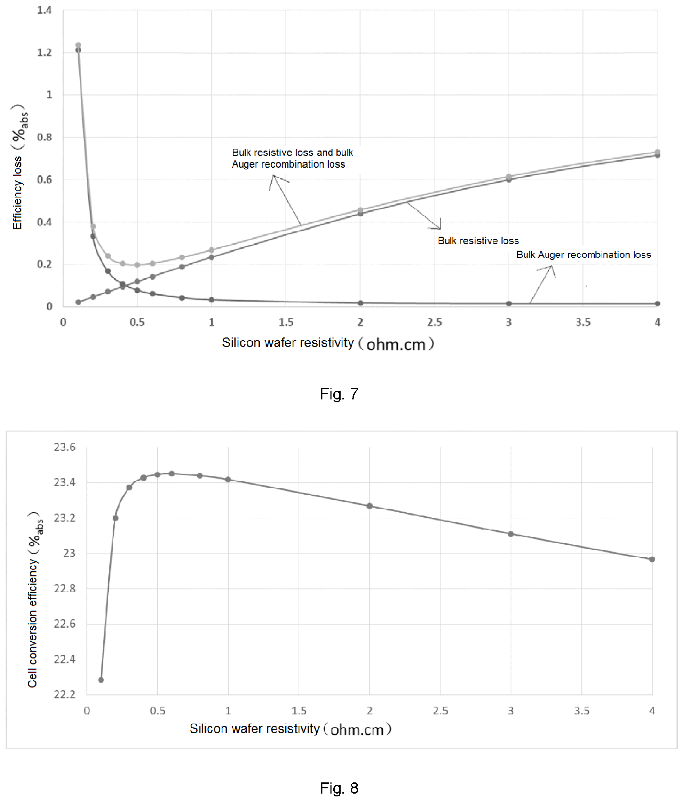

Second, considerations regarding the upper and lower limits of silicon substrate resistivity specifications
As shown in Fig. 7, Fig. 7 is a simulation result graph of the relationship between the bulk resistive loss and bulk Auger recombination loss and the silicon substrate resistivity of PERC cells in the related art.

It can be determined from Fig. 7 that the resistive loss caused by bulk resistivity is approximately a linear function, with the loss increasing as the resistivity increases; Auger recombination is related to the square of the carrier concentration, and as resistivity decreases, the bulk Auger recombination loss rises rapidly. The sum of the two presents a concave curve, which forms the basis for defining the upper and lower limits of the resistivity specifications. It can be determined from Fig. 7 that the minimum value of the sum of the bulk resistive loss and the bulk Auger recombination loss occurred at 0.4-0.6 ohm.cm.

In addition, referring to Fig. 8, Fig. 8 is a simulation result graph of the relationship between the conversion efficiency of PERC cells and the silicon substrate resistivity in the related art.

It can be determined from Fig. 8 that the peak of cell conversion efficiency appears at a silicon substrate resistivity of approximately 0.4-0.6 ohm.cm. As the resistivity either increases or decreases, the conversion efficiency declines rapidly, with the efficiency reduction caused by decreasing resistivity being more pronounced. The underlying determining factor is the relationship between silicon substrate resistivity and resistive loss as well as Auger recombination loss.

When the resistivity is <0.3 ohm.cm or >1.5 ohm.cm, an efficiency decrease of >0.1% occurs in both cases. Considering that the efficiency loss due to decreasing resistivity is more rapid, along with issues related to product reliability, and taking into account the cost of the silicon substrate, the minimum resistivity is generally set at 0.4 ohm.cm, while the upper limit of resistivity can be set at 1.1 ohm.cm.

However, through in-depth research and verification by the inventors of the present disclosure, the following findings were made:
1. The bulk resistivity of the silicon substrate under illumination is related with the free carrier concentration. The doping of the silicon substrate affects the carrier concentration, which in turn influences the bulk resistivity of the silicon substrate under illumination, while the free carrier concentration is related to both the doping concentration and the nonequilibrium carrier concentration;
2. During the operation of a solar cell, nonequilibrium carriers are generated under illumination, and the nonequilibrium carriers affect the actual bulk resistivity (i.e., the bulk resistivity under illumination);
3. In cases where the bulk resistivity (resistivity under dark conditions) is higher, the bulk lifetime is longer. Under illumination, when recombination and photogeneration reach equilibrium, the nonequilibrium carrier concentration becomes higher. In other words, the longer the bulk lifetime, the higher the nonequilibrium carrier concentration, and the lower the bulk resistivity under illumination; and
4. There is a strict physical correlation between nonequilibrium carrier concentration, recombination, and cell voltage. As recombination decreases, the cell voltage increases, and the nonequilibrium carrier concentration also increases accordingly.

Therefore, if the nonequilibrium carrier concentration reaches a magnitude equal to or even higher than the doping concentration of the doping elements in the silicon substrate, the increase in nonequilibrium carrier concentration induced by an increase in the bulk resistivity of the silicon substrate (resistivity under dark conditions) can significantly reduce the bulk resistivity of the silicon substrate during operation under illumination (i.e., resistivity under illumination), thereby reducing the bulk resistive efficiency loss, then the resulting bulk resistive efficiency loss is smaller than that caused by using the low-resistivity, heavily doped silicon substrates in the related art. In other words, when the resistivity of the silicon substrate (resistivity under dark conditions) increases, the substantial rise in nonequilibrium carrier concentration actually reduces the resistive loss under illumination. At this point, the sum of resistive efficiency loss and Auger recombination efficiency loss (i.e., the overall efficiency loss) decreases monotonically with increasing resistivity.

In order to achieve this technical objective, through research by the inventors of the present disclosure, the following findings were made:
by using a back contact solar cell structure, and using first passivated contact structures 20, second passivated contact structures 30 and a back passivation film layer 40 on a back surface 11 of the back contact solar cell, without performing additional surface doping on a front surface 12 of the back contact solar cell (i.e. not having a front surface field) or using sufficiently low surface doping (i.e. forming a front surface field with a low doping concentration); alternatively, using a bifacial contact solar cell structure, and using a third passivated contact structure 301 and a fourth passivated contact structure 302 on two surfaces of the bifacial contact solar cell respectively, the front/back surface recombination of the solar cell 100 and the bifacial contact solar cell is significantly reduced, and thus the surface recombination lifetime can reach or exceed the bulk lifetime, thereby making the effective lifetime of the solar cell to be predominantly determined by the bulk lifetime.

Moreover, by adopting such a solar cell structure, the concentration of nonequilibrium carriers throughout the bulk transport channels of the cell during operation can be guaranteed to be at a relatively high level, thereby reducing or avoiding significant resistive losses caused by locally low nonequilibrium carrier concentrations.

That is to say, the inventors of the present disclosure have found, through research and verification, that by means of the design of the foregoing adaptive solar cell structure, the contradiction between the solar cell efficiency and the resistivity of the silicon substrate 10 can be solved, and the described inherent understanding is broke. The P-type doping elements and the N-type doping elements each having a doping concentration greater than 10¹² atoms/cm³ may be doped simultaneously, and the doping concentration of the two types of doping elements is controlled and the absolute value of the doping concentration difference between them is controlled to be less than 10¹⁴ atoms/cm³, thereby enabling the resistivity of the silicon substrate 10 to be greater than 50 ohm.cm, and also improving the conversion efficiency of the solar cell 100 even when the resistivity is relatively high. That is to say, the inventors of the present disclosure have found, through research and verification, that by adopting the technical solution of the present disclosure, a higher resistivity can be achieved by controlling the doping concentrations of two types of doping elements of different polarities to both be greater than 10¹² atoms/cm³, and by controlling the absolute value of the concentration difference between them to be less than 10¹⁴ atoms/cm³. Furthermore, the conversion efficiency of the solar cell 100 can be improved while maintaining high resistivity, thereby breaking the inherent understanding.

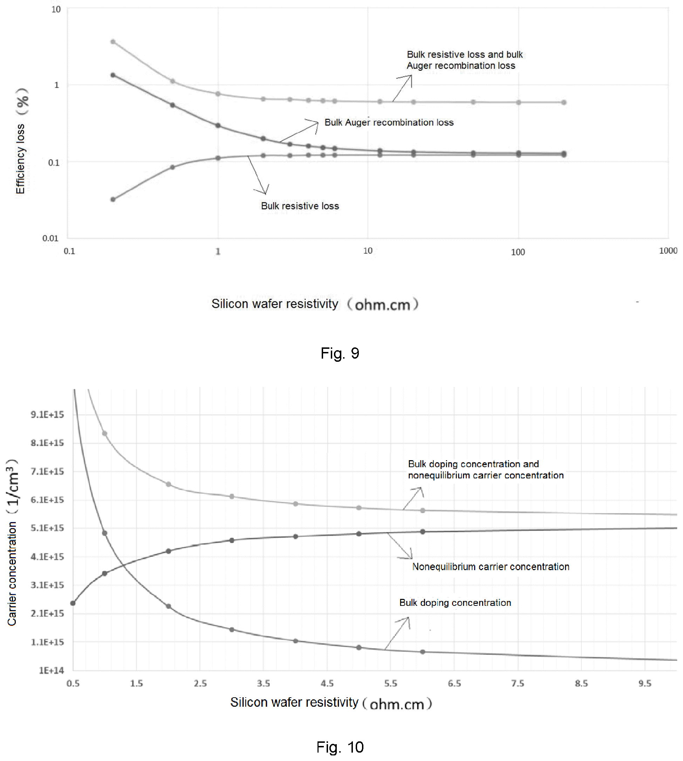

Specifically, the test simulation results of the back contact solar cell and the bifacial contact solar cell of the present disclosure employing the silicon substrate 10 of the present disclosure are shown in Figs. 9, 10 and 11.

Fig. 9 is a graph of the relationship between the bulk resistance loss and bulk Auger recombination loss and the silicon substrate resistivity (resistivity under dark conditions, i.e., "silicon wafer resistivity" in the figures) of the back contact solar cell and the bifacial contact solar cell of the present disclosure employing the silicon substrate 10 of the present disclosure.

It can be determined from Fig. 9 that, by adopting passivated contact technology for back contact solar cells and bifacial contact solar cells, the overall efficiency loss resulting from the sum of bulk resistive loss and bulk Auger recombination loss exhibits a monotonic decrease with increasing resistivity of the silicon substrate 10, thereby overcoming the aforementioned contradiction. That is, as the resistivity of the silicon substrate 10 increases, the overall efficiency loss of back contact solar cells and bifacial contact solar cells decreases correspondingly and ultimately converges.

Fig. 10 is a graph of the relationship between the carrier concentration and the silicon substrate resistivity of the back contact solar cell and the bifacial contact solar cell of the present disclosure employing the silicon substrate 10 of the present disclosure. The bulk doping concentration refers to the carrier concentration introduced by bulk doping, that is, the absolute value of the difference between the doping concentration of the P-type doping elements and the doping concentration of the N-type doping elements.

It can be determined from Fig. 10 that when the solar cell operates under illumination and the silicon substrate resistivity exceeds 1.3 ohm.cm, the nonequilibrium carrier concentration begins to exceed the bulk doping concentration. Ultimately, the increase in nonequilibrium carrier concentration resulting from the lifetime improvement due to the increase in bulk resistivity can compensate for the resistivity changes caused by the decrease in bulk doping concentration. That is to say, the increase in nonequilibrium carrier concentration resulting from the increase in the bulk resistivity of the silicon substrate (resistivity under dark conditions) can substantially reduce efficiency loss, thereby compensating for the efficiency loss caused by the reduced doping concentration. Meanwhile, comparing Fig. 10 with Fig. 8, it can be determined that, by using the technical solution of the present disclosure, compared with the technical solution in the related art, the conversion efficiency of the solar cell is greatly improved.

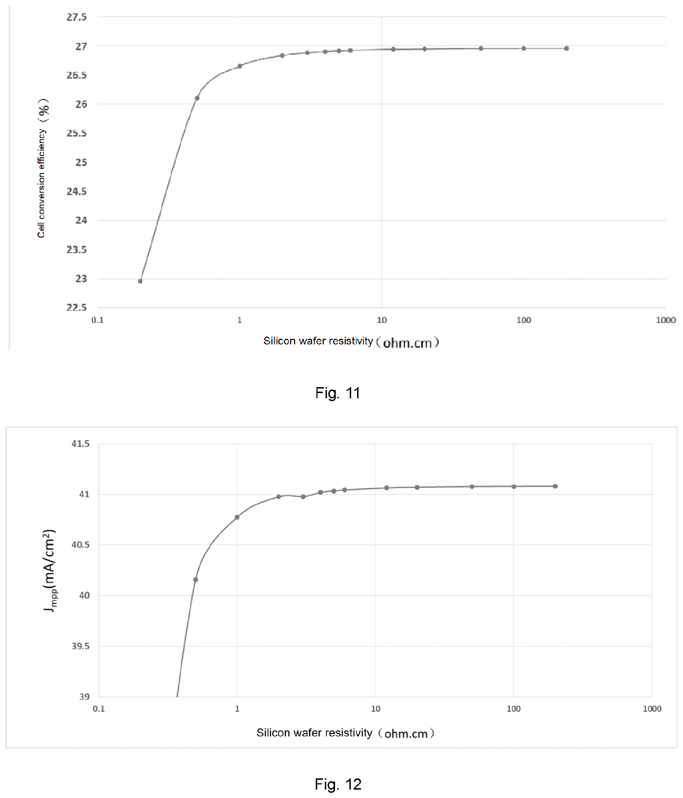

Fig. 11 is a graph of the relationship between the silicon substrate resistivity and the cell conversion efficiency of the back contact solar cell and the bifacial contact solar cell of the present disclosure employing the silicon substrate 10 of the present disclosure.

It can be determined from Fig. 11 that by using the silicon substrate 10 of the present disclosure and applying same to a solar cell 100 having first passivated contact structures 20, second passivated contact structures 30 and a back passivation film layer 40, or applying same to a bifacial contact solar cell having a third passivated contact structure 301 and a fourth passivated contact structure 302, as the resistivity of the silicon substrate 10 increases, the conversion efficiency of the solar cell rises monotonically and finally converges.

To sum up, in the present disclosure, the solar cell 100 using the silicon substrate 10 in the embodiments of the present disclosure can break the existing inherent understanding while effectively reducing the efficiency loss to improve the conversion efficiency of the solar cell.

In addition, the solar cell using the silicon substrate 10 of the present disclosure also achieves the following effects:

### 1. Reduced module mismatch

As shown in Fig. 12, Fig. 12 is a graph of the relationship between the silicon substrate resistivity and the maximum power point current of the back contact solar cell and the bifacial contact solar cell in the embodiments of the present disclosure.

It can be determined from Fig. 12 that as the resistivity increases, the maximum power point current increases and gradually stabilizes. When cells are assembled into modules, the cells are connected in series, requiring their final currents to be consistent. If there is a significant difference in Jₘₚₚ, mismatch issues between the cells will inevitably occur, preventing the cells from fully realizing their performance and causing a reduction in CTM (cell-to-module efficiency). Therefore, by proper adjustments to the cell structure and technology, high-resistivity silicon substrates (i.e., the silicon substrate 10 of the present disclosure) can be used for production, which will enhance the CTM efficiency of the module.

### 2. Enhanced resistance to non-ideal factors and increased power generation

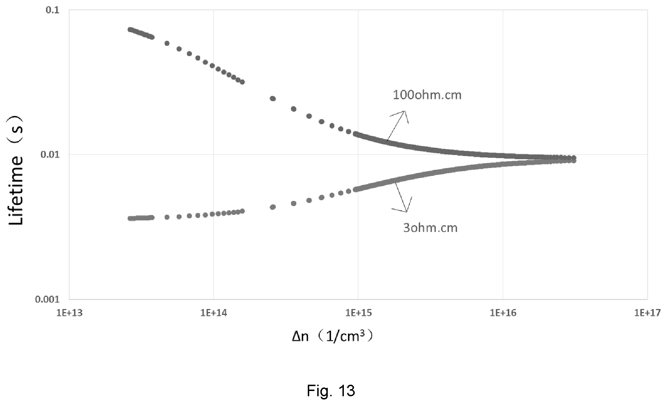

As shown in Fig. 13, Fig. 13 is a graph of the relationship between the concentration of nonequilibrium carriers and the SRH minority carrier lifetime of the solar cell 100 and the bifacial contact solar cell in the embodiments of the present disclosure, the horizontal axis represents the concentration of nonequilibrium carriers, and the vertical axis represents the SRH minority carrier lifetime.

Regarding the performance of lifetimes caused by defects with larger minority carrier capture cross-sections under different resistivities, it can be determined from Fig. 13 that when the resistivity increases, the lifetimes caused by defects with larger minority carrier capture cross-sections exhibit a significant advantage under low injection conditions. This indicates that efficiency losses caused by factors such as wafer splitting, surface scratches, and metal ions can be suppressed to a certain extent, leading to improved product performance. Furthermore, the increase in lifetime under low injection conditions results in improved performance under low irradiation, thereby enhancing the power generation per watt of the module and ultimately driving down the cost per kilowatt-hour.

### 3. Economic value of allowing production with high-resistivity silicon substrates

1) Cell efficiency gains: when the resistivity is increased to >50 ohm.cm, the average conversion efficiency improves by at least 0.05%, resulting in a cost reduction and product premium benefit of approximately 0.01 RMB/W.
2) Other gains: benefits from reduced module mismatch and reduced sensitivity to factors affecting lifetime under low-injection conditions vary depending on the actual technological level. Assuming an equivalent average efficiency improvement of 0.1%, the resulting cost reduction and product premium benefit is approximately 0.02 RMB/W.

Overall, the technical solution of the present disclosure is expected to yield a total benefit of approximately 0.041 RMB/W. In 2022, the production capacities of major domestic photovoltaic manufacturers were 85 GW, 65 GW, 65 GW, and 50 GW, with corresponding net profits of 14.8 billion, 2.93 billion, 3.68 billion, and 5.53 billion RMB, respectively. If the technical effects of the present disclosure were adopted, the corresponding additional profits would be approximately 3.485 billion, 2.665 billion, 2.665 billion, and 2.05 billion RMB, equivalent to increases of 23.5%, 91.0%, 72.4%, and 37.1% in net profit, respectively. This demonstrates significant economic value.

In the description of this specification, the reference terms "some embodiments", "illustrative embodiments", "examples", "specific examples", or "some examples" mean that the specific features, structures, materials or characteristics described in conjunction with the embodiments or examples are included in at least one embodiment or example of the present disclosure. In this specification, the illustrative expressions of the above terms do not necessarily refer to the same embodiment or example. Furthermore, the described specific features, structures, materials or characteristics may be combined in any suitable manner in one or more embodiments or examples.

In addition, the described content merely relates to preferred embodiments of the present disclosure, but are not intended to limit the present disclosure. Any modification, equivalent replacement, and improvement made within the spirit and principle of the present disclosure shall fall within the scope of protection of the present disclosure.

## Claims

1. A silicon substrate, wherein the silicon substrate is used for a solar cell, the silicon substrate is doped with both P-type doping elements and N-type doping elements, the P-type doping element comprises at least one of boron, aluminum, gallium, indium and thallium, and the N-type doping element comprises at least one of phosphorus, arsenic, antimony and bismuth; and
a sum of doping concentrations of the P-type doping elements and a sum of doping concentrations of the N-type doping elements are both greater than 10¹² atoms/cm³, an absolute value of a difference between the sum of the doping concentrations of the P-type doping elements and the sum of the doping concentrations of the N-type doping elements is less than 10¹⁴ atoms/cm³, and a resistivity of the silicon substrate after a thermal donor annihilation treatment is greater than 50 ohm.cm.

2. The silicon substrate according to claim 1, wherein the sum of the doping concentrations of the P-type doping elements and the sum of the doping concentrations of the N-type doping elements are both greater than 10¹⁴ atoms/cm³.

3. The silicon substrate according to claim 2, wherein the sum of the doping concentrations of the P-type doping elements and the sum of the doping concentrations of the N-type doping elements are both greater than 10¹⁵ atoms/cm³.

4. The silicon substrate according to claim 1, wherein the absolute value of the difference between the sum of the doping concentrations of the P-type doping elements and the sum of the doping concentrations of the N-type doping elements is less than 5*10¹³ atoms/cm³.

5. The silicon substrate according to claim 1, wherein the resistivity of the silicon substrate after the thermal donor annihilation treatment is greater than 100 ohm.cm.

6. The silicon substrate according to claim 4, wherein the resistivity of the silicon substrate after the thermal donor annihilation treatment is greater than 200 ohm.cm.

7. The silicon substrate according to claim 6, wherein the resistivity of the silicon substrate after the thermal donor annihilation treatment is greater than 500 ohm.cm.

8. The silicon substrate according to claim 7, wherein the resistivity of the silicon substrate after the thermal donor annihilation treatment is greater than 1000 ohm.cm.

9. The silicon substrate according to claim 8, wherein the resistivity of the silicon substrate after the thermal donor annihilation treatment is greater than 5000 ohm.cm.

10. The silicon substrate according to claim 1, wherein a thickness of the silicon substrate is 30 um to 300 um.

11. The silicon substrate according to claim 1, wherein the silicon substrate is a monocrystalline silicon substrate.

12. A solar cell, wherein the solar cell is a back contact solar cell, and the solar cell comprises:
the silicon substrate according to any one of claims 1-11, wherein a back surface of the silicon substrate is provided with several first regions and several second regions, and the several first regions and the several second regions are arranged alternately in sequence at intervals;
first passivated contact structures stacked on the first regions;
second passivated contact structures stacked on the second regions, the polarity of the second passivated contact structures being different from that of the first passivated contact structures; and
a back passivation film layer stacked on the first passivated contact structures and the second passivated contact structures.

13. The solar cell according to claim 12, wherein each of the first passivated contact structures comprises a first tunneling layer and a first polarity doping layer stacked on the first tunneling layer, the first polarity doping layer comprising at least one of doped polycrystalline silicon, doped amorphous silicon, and doped microcrystalline silicon; and
each of the second passivated contact structures comprises a second tunneling layer and a second polarity doping layer stacked on the second tunneling layer, the second polarity doping layer comprising at least one of doped polysilicon, doped amorphous silicon, and doped microcrystalline silicon, and the second polarity doping layer having a polarity opposite to that of the first polarity doping layer.

14. The solar cell according to claim 13, wherein trenches are provided between the first regions and the second regions, the first passivated contact structures are isolated from the second passivated contact structures by the trenches, and the trenches do not have a doped layer formed by doping elements from Group III or Group V; or
a dielectric film or an intrinsic silicon film layer is provided between the first regions and the second regions, and the first regions are isolated from the second regions by the dielectric film or the intrinsic silicon film layer.

15. The solar cell according to claim 12, wherein a front surface of the silicon substrate has no front surface field formed by doping, or the front surface of the silicon substrate has a front surface field with a surface doping concentration of less than 5*10¹⁸ atoms/cm³.

16. A solar cell, wherein the solar cell is a bifacial contact solar cell, and the solar cell comprises:
the silicon substrate according to any of claims 1-11, wherein the silicon substrate has a first surface and a second surface opposite to each other;
a third passivated contact structure stacked on the first surface; and
a fourth passivated contact structure stacked on the second surface.

17. The solar cell according to claim 16, wherein the third passivated contact structure comprises a third tunneling layer and a third polarity doping layer stacked on the third tunneling layer, the third polarity doping layer comprising at least one of doped polycrystalline silicon, doped amorphous silicon, and doped microcrystalline silicon; and
the fourth passivated contact structure comprises a fourth tunneling layer and a fourth polarity doping layer stacked on the fourth tunneling layer, the fourth polarity doping layer comprising at least one of doped polycrystalline silicon, doped amorphous silicon and doped microcrystalline silicon, and the fourth polarity doping layer having a polarity opposite to that of the third polarity doping layer.

18. A cell assembly, comprising the solar cell according to any one of claims 12-17.

19. A photovoltaic system, comprising the cell assembly according to claim 18.
